# EUROPEAN PATENT APPLICATION

(11) **EP 4 660 653 A1**
(43) Date of publication of application: **10.12.2025**
(21) Application number: 24750498.8
(22) Date of filing: 25.01.2024
(51) Int. Cl.: G01R 31/396, G01R 31/3842, G01R 31/36, G01R 31/385, G01R 19/12

(54) **BATTERY DIAGNOSTIC DEVICE AND OPERATION METHOD THEREOF**

(30) Priority: 03.02.2023 KR 20230015193
(71) Applicant: LG Energy Solution, Ltd., Seoul 07335 (KR)
(72) Inventor: PARK, Jae Dong, Daejeon 34122 (KR)
(74) Representative: Plasseraud IP
(86) International application number: PCT/KR2024/001230
(87) International publication number: WO 2024/162696

(57) **Abstract**

A battery unit diagnosis apparatus according to an embodiment disclosed herein includes a data obtaining unit configured to obtain charging/discharging data during charging/discharging of a battery unit, wherein the charging/discharging data includes charging/discharging profiles obtained during charging/discharging of the battery unit according to different charging/discharging rates, a profile obtaining unit configured to obtain first current-voltage profiles based on the charging/discharging profiles, a profile calculating unit configured to calculate a second current-voltage profile according to a designated charging/discharging rate that is different from the different charging/discharging rates, based on the first current-voltage profiles, and a data calculating unit configured to calculate capacity-voltage relationship data based on the second current-voltage profile.

## Description

### [Technical Field]

### CROSS-REFERENCE TO RELATED APPLICATION

This application claims priority to and the benefit of Korean Patent Application No. 10-2023-0015193 filed in the Korean Intellectual Property Office on February 3, 2023, the entire content of which is incorporated herein by reference.

### TECHNICAL FIELD

Embodiments disclosed herein relate to a battery diagnosis apparatus and an operating method thereof.

### [Background Art]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices. In addition, the lithium-ion battery is attracting attention as a next-generation energy storage medium as a usage range thereof is expanded to a power source of electric vehicles.

Furthermore, the secondary battery may be used as a battery pack including a battery module where a plurality of battery cells are connected to one another in series and/or in parallel. The secondary battery may be used as a battery rack including a plurality of battery modules and a rack frame receiving the battery modules.

The battery cell, the battery module, the battery pack, or the battery rack may be used in various devices. For example, the batteries may be used not only for mobile devices such as mobile phones, laptop computers, smart phones, smart pads, etc., but also in the field of vehicles (EV, HEV, PHEV) driven with electricity, large-volume energy storage systems (ESS), etc.

These batteries may be managed and controlled in terms of states and operations thereof by a battery management system (BMS). The battery management system may be included together with a battery in one device. The battery management system may also manage and control the battery in a state of being spaced apart from a device including the battery.

### [Disclosure]

### [Technical Problem]

A battery management system may measure various parameters of a battery to diagnose a state of the battery. However, some (e.g., a charge amount) of parameters measured to diagnose the state of the battery may be affected by an over-potential generated during charging/discharging of the battery.

There is a need for a scheme to obtain a precise charging/discharging profile of the battery by reducing an influence of the over-potential.

Technical problems of the embodiments disclosed herein are not limited to the above-described technical problems, and other unmentioned technical problems would be clearly understood by one of ordinary skill in the art from the following description.

### [Technical Solution]

A battery unit diagnosis apparatus according to an embodiment disclosed herein includes a data obtaining unit configured to obtain charging/discharging data during charging/discharging of a battery unit, wherein the charging/discharging data includes charging/discharging profiles obtained during charging/discharging of the battery unit according to different charging/discharging rates, a profile obtaining unit configured to obtain first current-voltage profiles based on the charging/discharging profiles, a profile calculating unit configured to calculate a second current-voltage profile according to a designated charging/discharging rate that is different from the different charging/discharging rates, based on the first current-voltage profiles, and a data calculating unit configured to calculate capacity-voltage relationship data based on the second current-voltage profile.

An operating method of a battery unit diagnosis apparatus according to an embodiment disclosed herein includes obtaining charging/discharging data during charging/discharging of a battery unit, wherein the charging/discharging data includes charging/discharging profiles obtained during charging/discharging of the battery unit according to different charging/discharging rates, obtaining first current-voltage profiles based on the charging/discharging profiles, calculating a second current-voltage profile according to a designated charging/discharging rate that is different from the different charging/discharging rates, based on the first current-voltage profiles, and calculating capacity-voltage relationship data based on the second current-voltage profile.

### [Advantageous Effects]

A battery diagnosis apparatus and an operating method thereof according to various embodiments disclosed herein may obtain a precise charging/discharging profile of a battery by reducing an influence of an over-potential.

The battery diagnosis apparatus and the operating method thereof according to various embodiments disclosed herein may precisely measure a relationship between a charge change amount and a voltage change amount of a battery by obtaining the precise charging/discharging profile.

Effects of the battery diagnosis apparatus and the operating method thereof according to the present disclosure are not limited to the above-described effects, and other unmentioned effects would be clearly understood by one of ordinary skill in the art from the following description.

### [Description of Drawings]

FIG. 1 is a block diagram of a battery diagnosis apparatus according to an embodiment of the present disclosure.
FIG. 2 is a flowchart showing an operating method of a battery diagnosis apparatus according to an embodiment of the present disclosure.
FIG. 3 is a flowchart showing an operation, performed by a battery diagnosis apparatus, of obtaining a current-voltage profile according to an embodiment of the present disclosure.
FIG. 4 is a flowchart showing an operation, performed by a battery diagnosis apparatus, of reducing an over-potential according to an embodiment of the present disclosure.

With regard to the description of the drawings, similar reference numerals may be used to refer to similar or related components.

### [Mode for Invention]

Hereinafter, embodiments of the present disclosure will be described with reference to the accompanying drawings. However, the description is not intended to limit the present disclosure to particular embodiments, and it should be construed as including various modifications, equivalents, and/or alternatives according to the embodiments of the present disclosure.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1^{st}", "2^{nd}," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly or wirelessly), or indirectly (e.g., via a third element).

A method according to various embodiments disclosed herein may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to embodiments disclosed herein, each component (e.g., a module or a program) of the above-described components may include a single entity or multiple entities, and some of the multiple entities may be separately disposed in different components. According to various embodiments disclosed herein, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to embodiments disclosed herein, operations performed by the module, the program, or another component may be carried out sequentially, in parallel, repeatedly, or heuristically, or one or more of the operations may be executed in a different order or omitted, or one or more other operations may be added.

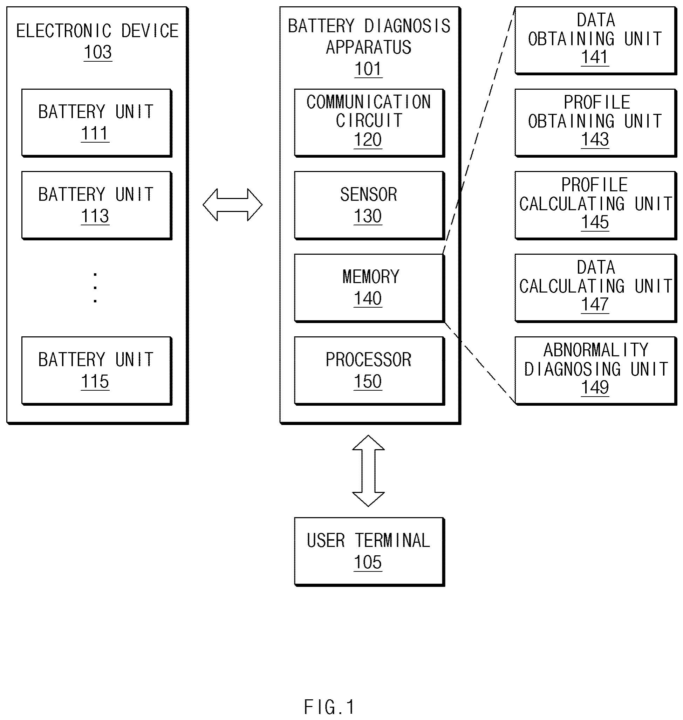

FIG. 1 is a block diagram of a battery diagnosis apparatus 101 according to an embodiment of the present disclosure.

Referring to FIG. 1, the battery diagnosis apparatus 101 may be wiredly and/or wirelessly connected to an electronic device 103 and a user terminal 105.

In an embodiment, connection between the battery diagnosis apparatus 101 and the electronic device 103 may be communication connection through a wired and/or wireless network. In an embodiment, the wired network may be based on a local area network (LAN) communication or a power-line communication. In an embodiment, the wireless network may be based on a short-range communication network (e.g., Bluetooth, Wireless Fidelity (WiFi), or Infrared Data Association (IrDA)) or a remote-range communication network (e.g., a cellular network, a 4^{th}-Generation (4G) network, a 5^{th}-Generation (5G) network).

In another embodiment, the connection between the battery diagnosis apparatus 101 and the electronic device 103 may be connection using a device-to-device communication scheme (e.g., a bus, a general-purpose input and output (GPIO), a serial peripheral interface (SPI), or a mobile industry processor interface (MIPI)).

In an embodiment, the connection between the battery diagnosis apparatus 101 and the user terminal 105 may be communication connection through a wired and/or wireless network.

In an embodiment, the electronic device 103 may be a mobile device (e.g., a mobile phone, a laptop computer, a smart phone, a smart pad), an electric vehicle (e.g., an electric vehicle (EV), a hybrid EV (HEV), a plug-in HEV (PHEV), a fuel cell EV (FCEV)), an energy storage system (ESS), or a battery swapping system (BSS).

In an embodiment, the electronic device 103 may include one or more battery units 111, 113, and 115. Each of the one or more battery units 111, 113, and 115 may be a battery cell, a battery module, a battery pack, or a battery rack. In an embodiment, each of one or more battery units 111, 113, and 115 may be used as a power source of the electronic device 103.

In an embodiment, the user terminal 105 may be a mobile device (e.g., a mobile phone, a laptop computer, a smart phone, a smart pad), or a personal computer (PC).

In an embodiment, the battery diagnosis apparatus 101 may include a communication circuit 120, a sensor 130, a memory 140, and a processor 150. According to an embodiment, the battery diagnosis apparatus 101 shown in FIG. 1 may further include at least one component (e.g., a display, an input device, or an output device) in addition to components shown in FIG. 1.

In an embodiment, the communication circuit 120 may establish a wired communication channel and/or a wireless communication channel between the battery diagnosis apparatus 101 and the electronic device 103 and/or the user terminal 105, and transmit and receive data to and from the electronic device 103 and/or the user terminal 105 through the established communication channel.

In an embodiment, the sensor 130 may obtain values related to states of the battery units 111, 113, and 115 of the electronic device 103. In an embodiment, the values related to the states may indicate one or more values of voltages, currents, resistances, SOC, states of health (SOH), or temperatures of the battery units 111, 113, and 115 or combinations thereof. Hereinbelow, the value related to the state may be referred to as a 'state value'.

In an embodiment, the memory 140 may include a volatile and/or a nonvolatile memory.

In an embodiment, the memory 140 may store data used by at least one component (e.g., the processor 150) of the battery state estimation apparatus 100. For example, the data may include software (or an instruction related thereto), input data, or output data. In an embodiment, the instruction, when executed by the processor 150, may cause the battery diagnosis apparatus 101 to perform operations defined by the instruction.

In an embodiment, the memory 140 may include one or more software (e.g., an obtaining unit 141, a profile obtaining unit 143, a profile calculating unit 145, a data calculating unit 147, and an abnormality diagnosing unit 149).

In an embodiment, the processor 150 may include a central processing unit, an application processor, a graphic processing unit, a neural processing unit (NPU), an image signal processor, a sensor hub processor, or a communication processor.

In an embodiment, the processor 150 may execute software (e.g., the obtaining unit 141, the profile obtaining unit 143, the profile calculating unit 145, the data calculating unit 147, and the abnormality diagnosing unit 149) to control at least one other component (e.g., a hardware or software component) of the battery diagnosis apparatus 101 connected to the processor 150 and perform various data processing or operations.

Hereinbelow, by using the battery unit 111 among the battery units 111, 113, and 115, as an example, a method, performed by the battery diagnosis apparatus 101, of diagnosing abnormality of the battery unit 111 through the data obtaining unit 141, the profile obtaining unit 143, the profile calculating unit 145, the data calculating unit 147, and the abnormality diagnosing unit 149 will be described.

In an embodiment, the data obtaining unit 141 may obtain charging/discharging data during charging/discharging of the battery unit 111. In an embodiment, the charging/discharging data may include charging/discharging profiles obtained during charging/discharging of the battery unit 111 according to different charging/discharging rates (C-rates). Herein, the charging/discharging profile may include information about a voltage, a current, a temperature, and/or an SOC of the battery unit 111 during charging/discharging of the battery unit 111. In an embodiment, the different charging/discharging rates may include 0.1C, 0.2C, 0.3C, or 1C. However, the different charging/discharging rates may be merely examples, without being limited thereto.

In an embodiment, the data obtaining unit 141 may obtain charging/discharging data by using the communication circuit 120. For example, the data obtaining unit 141 may receive the charging/discharging data, obtained by the electronic device 103 during charging/discharging of the battery unit 111, by using the communication circuit 120.

In an embodiment, the data obtaining unit 141 may obtain charging/discharging data by using the sensor 130. For example, the data obtaining unit 141 may receive sensed charging/discharging data, obtained by the sensor 130 during charging/discharging of the battery unit 111, from the sensor 130.

In an embodiment, the profile obtaining unit 143 may obtain current-voltage profiles based on the charging/discharging profiles. In an embodiment, the current-voltage profile may include information about a relationship between a current change amount and a voltage change amount in a designated state of charge (SOC) period. In an embodiment, the designated SOC period may include any SOC period (i.e., 0 % to 100 %). In an embodiment, the designated SOC period may include a limited SOC period (i.e., 10 % to 80 %).

In an embodiment, the profile obtaining unit 143 may calculate a first change amount indicating a voltage change amount with respect to a current change amount in a designated SOC period for each charging/discharging profile. For example, in case that the SOC period for calculating the first change amount is 0 % to 100 % and the first change amount is calculated each time when the SOC increases by 0.1 %, the profile obtaining unit 143 may calculate 1000 first change amounts for each charging/discharging profile.

In an embodiment, the profile obtaining unit 143 may obtain first current-voltage profiles for the charging/discharging profiles, based on the first change amount. Herein, the first current-voltage profiles may include the first change amount as information about a relationship between a current change amount and a voltage change amount.

In an embodiment, the first change amount may be obtained for each designated SOC interval from the designated SOC period. For example, the designated SOC interval may equal 0.1 %. However, the designated SOC interval may have various intervals without being limited thereto. In an embodiment, the first change amount may have a value dV/dI obtained by differentiating a voltage V by a current I in the designated SOC period.

In an embodiment, the profile obtaining unit 143 may obtain the first current-voltage profiles for the charging/discharging profiles, based on a second change amount obtained by adjusting the first change amount. Herein, the first current-voltage profiles may include the second change amount as information about a relationship between a current change amount and a voltage change amount.

More specifically, the profile obtaining unit 143 may obtain the second change amount in a first SOC of the SOC period, by adjusting the first change amount calculated in the first SOC based on other first change amounts calculated in second SOCs adjacent to the first SOC. The profile obtaining unit 143 may obtain the second change amount in the SOC period by applying the process of obtaining the second change amount to the entire SOC period. For example, in case that the first change amount is calculated each time when the SOC increases by 0.1 %. the profile obtaining unit 143 may obtain the second change amount in a specific SOC (e.g., 10 %) based on the first change amount in the specific SOC (e.g., 10 %) and first change amounts in adjacent SOCs (e.g., 9.9 % and 10.1 %). Herein, adjustment may include averaging or weighted averaging. In an embodiment, adjustment may also be referred to as smoothing. In an embodiment, it has been described that the second change amount is obtained based on three consecutive first change amounts, but it is merely an example. The number of consecutive first change amounts is not limited, and various window ranges (e.g., 5, 7, etc.) may be adopted.

In an embodiment, the profile obtaining unit 145 may calculate a second current-voltage profile according to a designated charging/discharging rate that is different from different charging/discharging rates, based on the first current-voltage profiles. Herein, the designated charging/discharging rate may be less than different charging/discharging rates. For example, when the least charging/discharging rate among the different charging/discharging rates is 0.1 C, the designated charging/discharging rate may be less than 0.1 C. For example, the designated charging/discharging rate may be close to 0 C, for example, 0.01 C, 0.001 C, or a charging/discharging rate less than 0.001 C.

In an embodiment, the profile calculating unit 145 may identify an over-potential in the designated SOC period based on the first current-voltage profiles. In an embodiment, the profile calculating unit 145 may identify a voltage change amount with respect to a current change amount due to the over-potential, based on the first current-voltage profiles. More specifically, the profile calculating unit 145 may identify a value dV/dI obtained by differentiating the voltage V increasing by the over-potential by the current I based on the first current-voltage profiles.

In an embodiment, the profile calculating unit 145 may identify change amounts indicating a voltage change amount with respect to a current change amount according to different charging/discharging rates in a designated SOC period, based on the first current-voltage profiles. Thereafter, the profile calculating unit 145 may identify the over-potential according to the change amounts in the designated SOC period by using a designated relationship between a charging/discharging rate and a change amount. Herein, the designated relationship may include a first-order equation, a second-order equation, a third-order equation, and an n^{th}-order equation (n is an integer of 4 or greater) using a feature that the over-potential increases as the charging/discharging rate increases.

In an embodiment, the profile calculating unit 145 may obtain the second current-voltage profile by excluding the identified over-potential from the first current-voltage profiles. For example, the profile calculating unit 145 may obtain the second current-voltage profile by excluding the identified over-potential from at least one first current-voltage profile among the first current-voltage profiles. Herein, the at least one first current-voltage profile may be a profile previously selected among the first current-voltage profiles. For example, the at least one first current-voltage profile may be a first current-voltage profile based on a charging/discharging profile obtained by the least charging/discharging rate.

In an embodiment, the profile calculating unit 145 may obtain the second current-voltage profile by removing the voltage change amount with respect to the current change amount due to the over-potential from the at least one first current-voltage profile. In an embodiment, the profile calculating unit 145 may obtain the second current-voltage profile by removing the value dV/dI obtained by differentiating the voltage V increasing due to the over-potential by the current I from the at least one first current-voltage profile.

In an embodiment, the data calculating unit 147 may calculate capacity-voltage relationship data based on the second current-voltage profile. Herein, the capacity-voltage relationship data may indicate a relationship between a capacity change amount and a voltage change amount at a designated charging/discharging rate of the battery unit. For example, the relationship between the capacity change amount and the voltage change amount may include a value dV/dQ obtained by differentiating the voltage V by a charge Q and/or a value dQ/dV obtained by differentiating the charge Q by the voltage V.

In an embodiment, the abnormality diagnosing unit 149 may diagnose whether the battery unit 111 is abnormal based on the capacity-voltage relationship data.

The battery diagnosis apparatus 101 may obtain a precise charging/discharging profile of the battery unit 111 that reduces an influence of the over-potential.

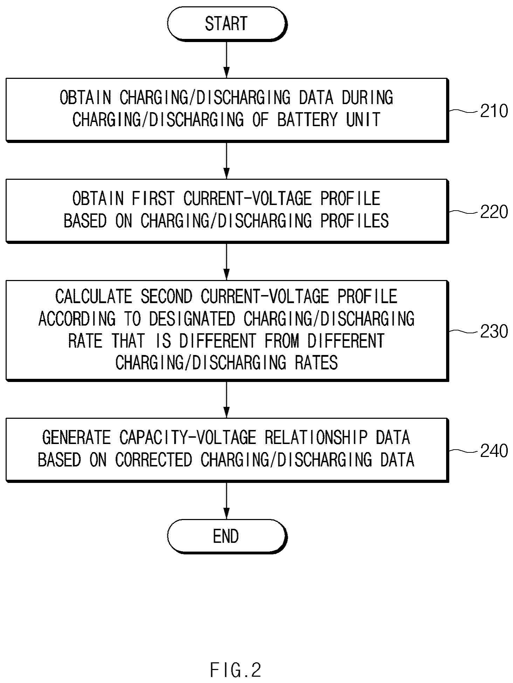

FIG. 2 is a flowchart showing an operating method of the battery diagnosis apparatus 101 according to an embodiment of the present disclosure. FIG. 2 will be described with reference to the components of the battery diagnosis apparatus 101 of FIG. 1.

Referring to FIG. 2, in operation 210, the battery diagnosis apparatus 101 may obtain charging/discharging data during charging/discharging of the battery unit 111. In an embodiment, the battery diagnosis apparatus 101 may obtain charging/discharging data by using the communication circuit 120 and/or the sensor 130. In an embodiment, the charging/discharging data may include charging/discharging profiles obtained during charging/discharging of the battery unit 111 according to different charging/discharging rates. Herein, the charging/discharging profile may include information about a voltage, a current, a temperature, and/or an SOC of the battery unit 111 during charging/discharging of the battery unit 111.

In operation 220, the battery diagnosis apparatus 101 may obtain the first current-voltage profiles based on the charging/discharging profiles. In an embodiment, the first current-voltage profile may include information about a relationship between a current change amount and a voltage change amount in a designated SOC period. In an embodiment, the designated SOC period may include any SOC period (i.e., 0 % to 100 %). In an embodiment, the designated SOC period may include a limited SOC period (i.e., 10 % to 80 %).

In operation 230, the battery diagnosis apparatus 101 may calculate a second current-voltage profile according to a designated charging/discharging rate that is different from different charging/discharging rates, based on the first current-voltage profiles. Herein, the designated charging/discharging rate may be less than different charging/discharging rates. For example, when the least charging/discharging rate among the different charging/discharging rates is 0.1 C, the designated charging/discharging rate may be less than 0.1 C. For example, the designated charging/discharging rate may be close to 0 C, for example, 0.01 C, 0.001 C, or a charging/discharging rate less than 0.001 C.

In operation 240, the battery diagnosis apparatus 101 may calculate capacity-voltage relationship data based on the second current-voltage profile. Herein, the capacity-voltage relationship data may indicate a relationship between a capacity change amount and a voltage change amount at a designated charging/discharging rate of the battery unit. For example, the relationship between the capacity change amount and the voltage change amount may include a value dV/dQ obtained by differentiating the voltage V by a charge Q and/or a value dQ/dV obtained by differentiating the charge Q by the voltage V.

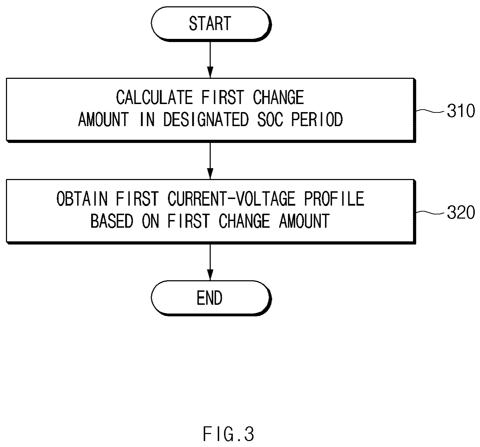

FIG. 3 is a flowchart showing an operation, performed by the battery diagnosis apparatus 101, of obtaining a current-voltage profile according to an embodiment of the present disclosure. Operations of FIG. 3 may be included in operation 220 of FIG. 2. FIG. 3 will be described with reference to the components of the battery diagnosis apparatus 101 of FIG. 1.

Referring to FIG. 3, in operation 310, the battery diagnosis apparatus 101 may calculate the first change amount in the designated SOC period. For example, in case that the SOC period for calculating the first change amount is 0 % to 100 % and the first change amount is calculated each time when the SOC increases by 0.1 %, the battery diagnosis apparatus 101 may calculate 1000 first change amounts for each charging/discharging profile. Herein, the first change amount may indicate a voltage change amount with respect to a current change amount in the designated SOC period for each charging/discharging profile.

In operation 320, the battery diagnosis apparatus 101 may obtain the first current-voltage profiles based on the first change amount. Herein, the first current-voltage profiles may include the first change amount as information about a relationship between a current change amount and a voltage change amount. In an embodiment, the first change amount may have a value dV/dI obtained by differentiating a voltage V by a current I in the designated SOC period.

In an embodiment, the battery diagnosis apparatus 101 may obtain the first current-voltage profiles for the charging/discharging profiles, based on a second change amount obtained by adjusting the first change amount. Herein, the first current-voltage profiles may include the second change amount as information about a relationship between a current change amount and a voltage change amount.

In an embodiment, the battery diagnosis apparatus 101 may obtain the second change amount in a first SOC of the SOC period, by adjusting the first change amount calculated in the first SOC based on other first change amounts calculated in second SOCs adjacent to the first SOC. Herein, adjustment may include averaging or weighted averaging. In an embodiment, adjustment may also be referred to as smoothing.

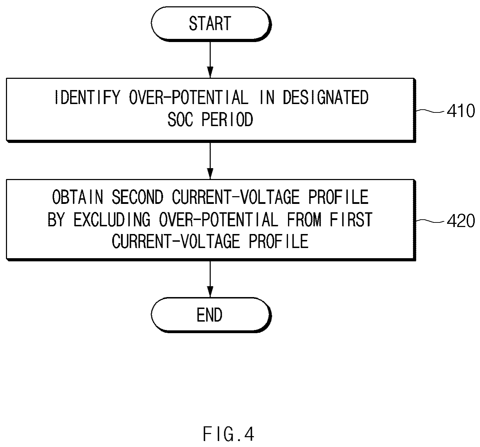

FIG. 4 is a flowchart showing an operation, performed by the battery diagnosis apparatus 101, of reducing an over-potential according to an embodiment of the present disclosure. Operations of FIG. 4 may be included in operation 230 of FIG. 2. FIG. 4 will be described with reference to the components of the battery diagnosis apparatus 101 of FIG. 1.

Referring to FIG. 4, in operation 410, the battery diagnosis apparatus 101 may identify the over-potential in the designated SOC period. In an embodiment, the battery diagnosis apparatus 101 may identify a voltage change amount with respect to a current change amount due to the over-potential, based on the first current-voltage profiles. More specifically, the battery diagnosis apparatus 101 may identify the value dV/dI obtained by differentiating the voltage V increasing by the over-potential by the current I based on the first current-voltage profiles.

In an embodiment, the battery diagnosis apparatus 101 may identify change amounts indicating a voltage change amount with respect to a current change amount according to different charging/discharging rates in a designated SOC period, based on the first current-voltage profiles. Thereafter, the battery diagnosis apparatus 101 may identify the over-potential according to the change amounts in the designated SOC period by using a designated relationship between a charging/discharging rate and a change amount. Herein, the designated relationship may include the first-order equation, the second-order equation, the third-order equation, and the n^{th}-order equation (n is an integer of 4 or greater) using the feature that the over-potential increases as the charging/discharging rate increases.

In operation 420, the battery diagnosis apparatus 101 may obtain the second current-voltage profile by excluding the over-potential from the first current-voltage profile. For example, the battery diagnosis apparatus 101 may obtain the second current-voltage profile by excluding the identified over-potential from at least one first current-voltage profile among the first current-voltage profiles. Herein, the at least one first current-voltage profile may be a profile previously selected among the first current-voltage profiles. For example, the at least one first current-voltage profile may be a first current-voltage profile based on a charging/discharging profile obtained by the least charging/discharging rate.

In an embodiment, the battery diagnosis apparatus 101 may obtain the second current-voltage profile by removing the voltage change amount with respect to the current change amount due to the over-potential from the at least one first current-voltage profile. In an embodiment, the battery diagnosis apparatus 101 may obtain the second current-voltage profile by removing the value dV/dI obtained by differentiating the voltage V increasing due to the over-potential by the current I from the at least one first current-voltage profile.

## Claims

1. A battery unit diagnosis apparatus comprising:
a data obtaining unit configured to obtain charging/discharging data during charging/discharging of a battery unit, wherein the charging/discharging data comprises charging/discharging profiles obtained during charging/discharging of the battery unit according to different charging/discharging rates;
a profile obtaining unit configured to obtain first current-voltage profiles based on the charging/discharging profiles;
a profile calculating unit configured to calculate a second current-voltage profile according to a designated charging/discharging rate that is different from the different charging/discharging rates, based on the first current-voltage profiles; and
a data calculating unit configured to calculate capacity-voltage relationship data based on the second current-voltage profile.

2. The battery unit diagnosis apparatus of claim 1, wherein the profile obtaining unit is further configured to:
calculate a first change amount indicating a voltage change amount with respect to a current change amount in a designated state of charge (SOC) period for each of the charging/discharging profiles; and
obtain the first current-voltage profiles for the charging/discharging profiles based on the first change amount.

3. The battery unit diagnosis apparatus of claim 2, wherein the profile obtaining unit is further configured to:
obtain a second change amount in the SOC period, by adjusting the first change amount calculated in a first SOC of the SOC period based on other first change amounts calculated in second SOCs adjacent to the first SOC; and
obtain the first current-voltage profiles for the charging/discharging profiles based on the second change amount.

4. The battery unit diagnosis apparatus of claim 1, wherein the profile calculating unit is further configured to:
identify an over-potential in the designated SOC period based on the first current-voltage profiles; and
obtain the second current-voltage profile by excluding the identified over-potential from at least one first current-voltage profile among the first current-voltage profiles.

5. The battery unit diagnosis apparatus of claim 4, wherein the profile calculating unit is further configured to:
identify change amounts indicating a voltage change amount with respect to a current change amount according to the different charging/discharging rates in the designated SOC period, based on the first current-voltage profiles; and
identify the over-potential according to the change amounts in the designated SOC period by using a designated relationship between a charging/discharging rate and a change amount.

6. The battery unit diagnosis apparatus of claim 1, wherein the capacity-voltage relationship data indicates a relationship between a capacity change amount and a voltage change amount at a designated charging/discharging rate of the battery unit.

7. The battery unit diagnosis apparatus of claim 1, wherein the designated charging/discharging rate is less than the different charging/discharging rates.

8. An operating method of a battery unit diagnosis apparatus, the operating method comprising:
obtaining charging/discharging data during charging/discharging of a battery unit, wherein the charging/discharging data comprises charging/discharging profiles obtained during charging/discharging of the battery unit according to different charging/discharging rates;
obtaining first current-voltage profiles based on the charging/discharging profiles;
calculating a second current-voltage profile according to a designated charging/discharging rate that is different from the different charging/discharging rates, based on the first current-voltage profiles; and
calculating capacity-voltage relationship data based on the second current-voltage profile.

9. The operating method of claim 8, wherein the obtaining of the first current-voltage profiles comprises:
calculating a first change amount indicating a voltage change amount with respect to a current change amount in a designated state of charge (SOC) period for each of the charging/discharging profiles; and
obtaining the first current-voltage profiles for the charging/discharging profiles based on the first change amount.

10. The operating method of claim 9, wherein the obtaining of the first current-voltage profiles comprises:
obtaining a second change amount in the SOC period, by adjusting the first change amount calculated in a first SOC of the SOC period based on other first change amounts calculated in second SOCs adjacent to the first SOC; and
obtaining the first current-voltage profiles for the charging/discharging profiles based on the second change amount.

11. The operating method of claim 8, wherein the obtaining of the second current-voltage profiles comprises:
identifying an over-potential in the designated SOC period based on the first current-voltage profiles; and
obtaining the second current-voltage profile by excluding the identified over-potential from at least one first current-voltage profile among the first current-voltage profiles.

12. The operating method of claim 11, wherein the obtaining of the second current-voltage profiles comprises:
identifying change amounts indicating a voltage change amount with respect to a current change amount according to the different charging/discharging rates in the designated SOC period, based on the first current-voltage profiles; and
identifying the over-potential according to the change amounts in the designated SOC period by using a designated relationship between a charging/discharging rate and a change amount.

13. The operating method of claim 8, wherein the capacity-voltage relationship data indicates a relationship between a capacity change amount and a voltage change amount at a designated charging/discharging rate of the battery unit.

14. The operating method of claim 8, wherein the designated charging/discharging rate is less than the different charging/discharging rates.
